Europäisches Patentamt

**European Patent Office**

Office européen des brevets

(19)

(11) Numéro de publication: **0 119 927**
**B1**

# (12) FASCICULE DE BREVET EUROPEEN

(45) Date de publication du fascicule du brevet:
**10.12.86**

(21) Numéro de dépôt: **84400532.2**

(22) Date de dépôt: **15.03.84**

(51) Int. Cl.⁴: **H 03 K 4/02**, G 06 G 7/28,
**H 03 F 3/217**

(54) **Amplificateur haute tension pour charge capacitive.**

(30) Priorité: **18.03.83 FR 8304431**

(43) Date de publication de la demande:
**26.09.84 Bulletin 84/39**

(45) Mention de la délivrance du brevet:
**10.12.86 Bulletin 86/50**

(84) Etats contractants désignés:
**BE DE GB IT NL**

(56) Documents cités:
**US - A - 3 727 081**
**US - A - 3 742 252**
**US - A - 4 193 040**

**IBM TECHNICAL DISCLOSURE BULLETIN, vol. 19, no. 2,
juillet 1976, pages 376-377, New York, US; E.R.
WILLIAMS: "Up-down staircase generator"**
**ELECTRONIC ENGINEERING, vol. 37, no. 447, mai 1965,
pages 329-331, Londres, GB; A. WATSON et al.: "A
staircase function generator"**

(73) Titulaire: **ETAT-FRANCAIS représenté par le DELEGUE
GENERAL POUR L'ARMEMENT, Bureau des Brevets et
Inventions de la Délégation Générale pour
l'Armement 14, rue Saint-Dominique, F-75997 Paris
Armées (FR)**

(72) Inventeur: **Lafonta, Fernande, 40, rue Bezout,
F-75014 Paris (FR)**
Inventeur: **Lafonta, Paul, 40, rue Bezout, F-75014 Paris
(FR)**

## Description

La présente invention a pour objet un amplificateur haute tension pour charge capacitive et plus particulièrement un dispositif d'alimentation contrôlée d'une charge capacitive notable en signaux de tension de grande amplitude pouvant être par exemple de l'ordre du kilovolt.

Il est souvent nécessaire d'alimenter des charges capacitives, telles qu'un haut-parleur à électret, un tube Geiger Muller, ou un transducteur à ultrasons, par exemple, sous une tension d'alimentation élevée. Pour certaines applicatons particulières, il est de plus nécessaire d'asservir le niveau de tension appliqué à une charge capacitive, et éventuellement le profil de la tension appliquée, en fonction d'un signal d'entrée dont l'évolution peut être très rapide.

Les circuits d'attaque de charges capacitives devant être alimentées en signaux de haute tension de façon contrôlée mettent généralement en oeuvre des circuits de commutation rapide en tout ou rien de structures diverses qui nécessitent des puissances importantes.

De plus, les circuits connus d'alimentation de charges capacitives sont peu adaptés à la réalisation d'asservissements en temps réel pour des tensions de l'ordre du kilovolt avec des plages de variation de l'ordre de la dizaine de microseconde.

Enfin, dans la plupart des circuits connus, les impédances de sortie faibles peuvent se révéler très dangereuses pour l'utilisateur et il est nécessaire de prévoir des circuits auxiliaires de protecton contre les court-circuits. Par ailleurs, avec les circuits d'alimentation traditionnels, la haute tension est automatiquement présente sur la borne de sortie, même à vide, en l'absence d'une charge capacitive, ce qui s'avère peu satisfaisant pour des raisons de sécurité.

La présente invention vise précisément à remédier aux inconvénients précités et à permettre de réaliser un amplificateur haute tension pour charge capacitive qui présente un grand gain en puissance, soit de faible encombrement et de coût réduit, confère une possibilité d'asservissement de la tension appliquée en temps réel, permette un réglage aisé du profil de variation de la tension appliquée, sans adjonction de résistance, soit économe en énergie et garantisse une grande sécurité d'utilisation.

Ces buts sont attaints grâce à un dispositif d'alimentation contrôlée d'une charge capacitive en signaux de tension élevée, qui, conformément à l'invention, comprend un circuit de production d'impulsions de commande basse tension, un condensateur d'entrée qui présente une capacité très inférieure à celle de la charge capacitive et sur l'une des bornes duquel est appliqué le signal de commande, un élément non linéaire alimenté sous haute tension, qui constitue un tripôle actif avec un dipôle de commande et dont l'un des pôles du dipôle de commande est relié à la deuxième borne du condensateur d'entrée, tandis que l'autre pôle du dipôle de commande est connecté à l'une des bornes de la charge capacitive de sortie dont l'autre borne est reliée à la masse, et une diode à faibles fuites et à faible capacité qui est connectée entre les deux pôles dudit dipôle de commande de manière à constituer avec ce dernier un circuit fermé acceptant la circulation du courant dans un seul sens dans les conditions normales de fonctionnement.

De préférence, le circuit de production d'impulsions de commande basse tension comprend un générateur d'impulsions basse tension délivrant des impulsions sensiblement rectangulaires dont la hauteur et la période sont respectivement égales à la hauteur et à la largeur des marches de la tension en escalier qui doit être produite aux bornes de la charge capacitive.

Avantageusement, le tripôle actif est constitué par un transistor à effet de champ du type V-MOS, et la diode connectée entre les deux pôles du dipôle de commande du tripôle actif est constituée par une diode Zener rapide dont la tension de coude Zener set supérieure à la tension de seuil du tripôle actif.

Selon un premier mode de réalisation possible, la grille du transistor à effet de champ est connectée au condensateur d'entrée tandis que la source est connectée à la charge capacitive de sortie.

Selon un autre mode de réalisation possible, la source du transistor à effet de champ est connectée au condensateur d'entrée tandis que la grille est connectée à la charge capacitive de sortie.

Pour permettre d'effectuer une décharge rapide de la charge capacitive, le dispositif comprend des moyens de mise en court-circuit de la charge capacitive de sortie connectés entre la borne du condensateur d'entrée reliée au tripôle actif et la masse.

A titre d'exemple, les moyens de mise en court-circuit comprennent une résistance montée en série avec l'espace drain-source d'un transistor à effet de champ commandé par la grille.

Pour permettre de réaliser une décharge progressive et contrôlée de la charge capacitive, le dispositif comprend en outre un circuit de décharge contrôlée de la charge capacitive de sortie, lequel circuit de décharge contrôlée est relié à un second générateur d'impulsions qui délivre des impulsions sensiblement rectangulaire permettant au circuit de commande de décharge de décharger par palier à chaque impulsion la charge capacitive de sortie, la largeur d'un palier correspondant à la période des impulsions issues du second générateur d'impulsions.

Selon un mode de réalisation avantageux, le circuit de décharge contrôlée comprend un second condensateur d'entrée sur l'une des bornes duquel est appliqué le signal issu du second générateur d'impulsions, un élément non linéaire qui constitue un second tripôle actif, dont l'un des pôles du tripôle de commande est relié à la deuxième borne du second condensateur d'entrée tandis que l'autre pôle du dipôle de commande est connecté à l'une des bornes d'un condensateur de décharge dont l'autre borne est reliée à la masse, une diode à faibles fuites et à faible capacité qui est connectée entre les deux pôles du dipôle de commande du second tripôle actif de manière à constituer avec ce dernier un circuit fermé acceptant la circulation du courant dans un seul sens, et un élément de référence de tension ou d'écrêtage dont la tension de référence est inférieure à l'amplitude maximale des impulsions fournies par le second générateur d'impulsions, et qui est connecté en parallèle sur le condensateur de décharge, et le troisième pôle du second tripôle actif du circuit de décharge contrôlée est relié à la borne de la charge capacitive qui est connectée à l'un des pôles du dipôle de commande du premier tripôle actif.

Selon l'invention, une tension de sortie en marche d'escalier, croissante ou décroissante et de niveau élevé peut être appliquée sur une charge capacitive à partir de signaux basse tension d'entrée grâce à un amplificateur haute tension à intégration qui comprend un premier convertisseur courant-fréquence qui délivre des impulsions basse tension de hauteur et de fréquence prédéterminées pour commander l'application, sur une charge capacitive de sortie, d'une tension en escalier croissante dont la heuteur et la largeur des marches correspondant respectivement à l'amplitude et à la période des impulsions délivrées par le premier convertisseur courant-fréquence; un second convertisseur courant-fréquence qui délivre des impulsions basse tension de hauteur et de fréquence prédéterminées pour commander l'application, sur la charge capacitive de sortie, d'une tension en escalier décroissante dont la largeur des marches correspond à la période des impulsions délivrées par le second convertisseur courant-fréquence; un premier circuit d'application d'une tension en escalier croissante qui comprend un condensateur d'entrée auquel sont appliquées les impulsions issues du premier convertisseur courant-fréquence, un tripôle actif dont les pôles du dipôle de commande sont connectés respectivement au condensateur d'entrée et à la charge capacitive de sortie et le troisième pôle est relié à une source d'alimentation haute tension, et une diode rapide connectée entre les deux pôles dudit dipôle de commande de manière à constituer avec ce dernier un circuit fermé acceptant la circulation du courant dans un seul sens; et un second circuit d'application d'une tension en escalier décroissante qui comprend un condensateur d'entrée auquel sont appliquées les impulsions issues du second convertisseur courant-fréquence, un tripôle actif dont les pôles du dipôle de commande sont connectés respectivement au condensateur d'entrée et à un condensateur de décharge et le troisième pôle est relié à la charge capacitive de sortie, une diode rapide connectée entre les deux pôles du dipôle de commande de manière à constituer avec ce dernie un circuit fermé acceptant la circulation du courant dans un seul sens, et un élément de référence de tension.

D'autres caractéristiques et avantages de l'invention ressortiront de la description qui fait suite de modes particuliers de réalisation, donnée en référence au dessin annexé, sur lequel:

la figure 1 est une vue schématique montrant la commande en fréquence d'un amplificateur haute tension selon l'invention,

les figures 2a à 2d montrent des diagrammes temporels comparatifs des signaux d'entrée et de sortie du circuit de la figure 1,

la figure 3 représente le schéma d'un premier exemple de dispositif d'alimentation contrôlée d'une charge capacitive en signaux haute tension,

la figure 4 représente le schéma d'un second exemple de dispositif d'alimentation contrôlée d'une charge capacitive en signaux haute tension, lequel dispositif comporte deux circuits similaires couplés pour commander respectivement les flancs montant et descendant de la haute tension appliquée à la charge capacitive, et

la figure 5 montre un dispositif auquel sont appliqués des signaux d'entrée sinusoïdaux.

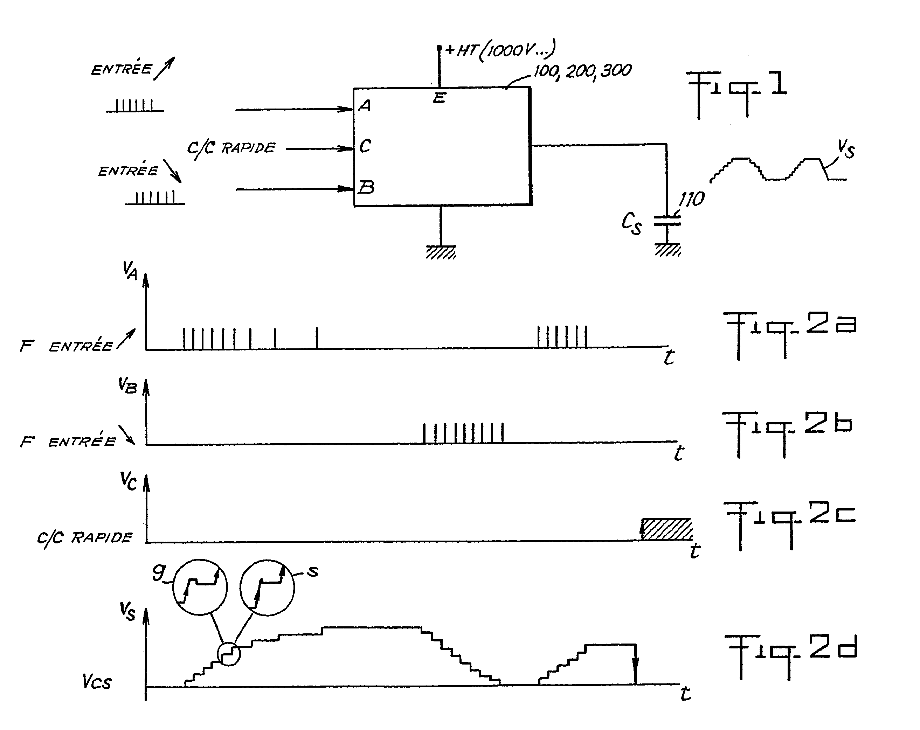

Les circuits 100, 200, 300 de la figure 1 schématisent un amplificateur destiné à appliquer sur une charge capacitive pure ou quasiment pure 110 un signal de tension $V_S$ dont l'amplitude est alternativement croissante et décroissante entre une valeur nulle ou très faible et une valeur maximale qui peut être par exemple de l'ordre du kilovolt. Les variations de la tension de sortie $V_S$ sont commandées à partir des entrées A, B, C qui reçoivent des signaux basse tension. La source d'alimentation haute tension est connectée à une borne indépendante E des circuits 100, 200, 300.

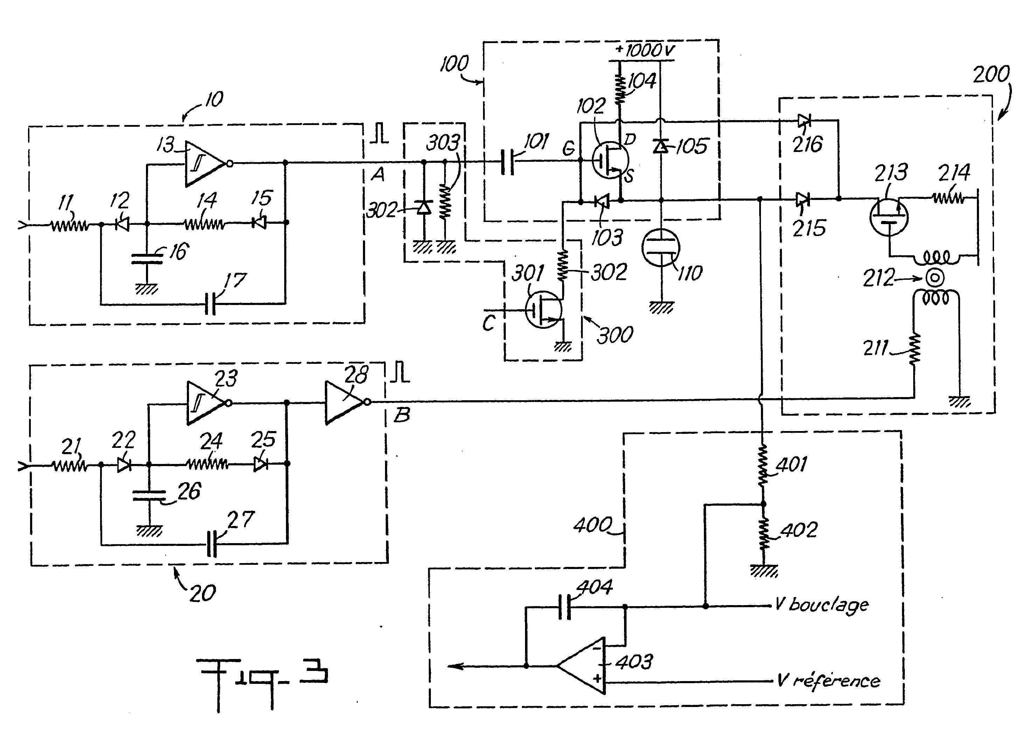

Un signal $V_A$ constitué par des impulsions d'amplitude et de fréquence prédéterminées est appliqué sur l'entrée A pour commander l'évolution des flancs montants du signal de sortie $V_S$. Comme on peut le voir sur les figures 2a et 2d, le flanc montant du signal de sortie $V_S$ est constitué par une rampe de montée en escalier telle que la hauteur des marches correspond approximativement à l'amplitude des impulsions $V_A$ et la largeur des marches correspond à l'intervalle de temps entre deux impulsions successives, c'est-à-dire à la période du signal $V_A$. La raideur du flanc de montée du signal $V_S$ peut ainsi être ajustée par une modification de la fréquence des impulsions d'entrée $V_A$. D'une façon similaire (figures 2b et 2d) les flancs descendants du signal de sortie $V_S$ peuvent être constitués par une rampe en escalier décroissante telle que la hauteur des marches correspond approximativement à l'amplitude des impulsions $V_B$ appliquées sur l'entrée B et la largeur des marches correspond également à l'intervalle de temps entre deux impulsions successives, c'est-à-dire à la période du signal $V_B$. Dans certains cas, il est souhaitable de pouvoir ramener à zéro instantanément la valeur de la tension aux bornes de la charge capacitive 110. Dans ce cas, un échelon de tension $V_C$ appliqué sur l'entrée C produit un effet de court-circuit rapide, de sorte que le flanc arrière du signal $V_S$ est alors pratiquement vertical.

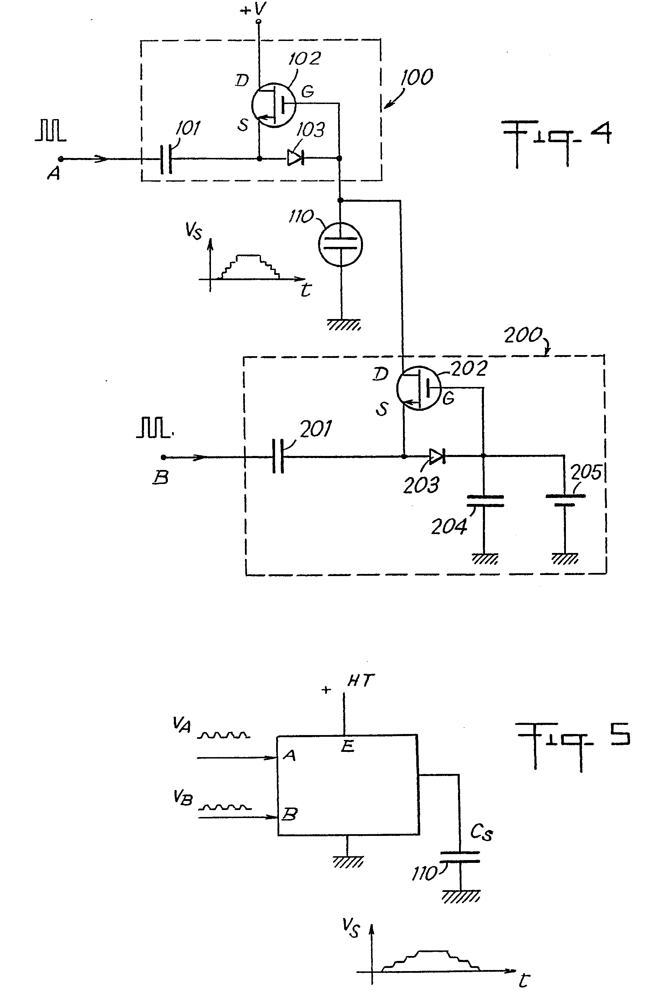

Les caractéristiques essentielles du dispositif selon l'invention seront mieux comprises si l'on considère l'exemple de réalisation de la figure 3.

Dans le schéma de la figure 3, on peut distinguer un circuit 100 d'alimentation en tension d'une charge capacitive 110, un circuit 10 de commande en fréquence du circuit 100 d'alimentation en tension, un circuit 300 de mise en court-circuit de la charge capacitive 110, un circuit 200 de décharge de la charge capacitive 110, un circuit 20 de commande en fréquence du circuit 200 de décharge et une boucle de régulation 400.

Les circuits 10 et 20 constituent des générateurs d'impulsions de forme sensiblement rectangulaire, dont les caractéristiques sont définies de manière à délivrer des impulsions d'amplitude et de fréquence prédéterminées. Dans l'application envisagée, la largeur des impulsions de commande n'intervient pas dans la détermination des caractéristiques du signal

de sortie $V_S$ du circuit 100, dès lors que cette largeur est supérieure à une valeur minimale qui dépend de la nature des composants utilisés. Les circuits 10 et 20 peuvent présenter des configurations classiques. Dans l'exemple de la figure 3, les circuits 10 et 20 sont constitués par des convertisseurs courant-fréquence auxquels sont appliqués des signaux de commande analogiques dont les caractéristiques peuvent prendre en compte les signaux de contre-réaction de la boucle de régulation 400.

A titre d'exemple, le circuit 10 comprend une résistance d'entrée 11 connectée à la cathode d'une diode 12 dont l'anode est connectée à la fois à un trigger de Schmidtt 13, à une extrémité d'une résistance 14 et à une borne d'un condensateur 16 dont l'autre borne est reliée à la masse. La deuxième extrémité de la résistance 14 est connectée à la cathode d'une deuxième diode 15 dont l'anode est elle-même connectée à la sortie un trigger de Schmidtt 13. Un condensateur 17 relie la sortie de la porte inverseuse 13 à la cathode de la diode 12. Le circuit convertisseur 20 comporte des éléments 21 à 27 qui sont respectivement similaires aux éléments 11 à 17 du circuit convertisseur 10. Toutefois, pour tenir compte de la polarité différente du signal analogique d'entrée, le sens de connexion des diodes 22 et 25 est inversé. Par ailleurs, une porte inverseuse supplémentaire 28 permet de disposer en sortie d'impulsions de polarité similaire à celle des impulsions issues du circuit convertisseur 10.

Le circuit 100 d'alimentation en tension de la charge capacitive 110 constitue un aspect important de la présente invention. Le circuit 100 est bâti autour d'un élément non linéaire constituant un tripôle actif 12. Ce tripôle actif peut être constitué par un transistor bipolaire à jonction, un montage du type Darlington, voire un tube à vide, mais est de préférence constitué par une transistor à effet de champ haute tension du type V MOS, qui est adapté pour fonctionner sous une forte tension de service, ne présente pas de second claquage, de donne lieu qu'à de très faibles fuites à l'état fermé et présente à la fois un gain en courant élevé et un temps de recouvrement négligeable. Un tel choix de compostant permet de s'affranchir notamment des inconvénients liés aux temps de récupération et aux phénomènes de saturation. Une diode 103 est connectée entre les pôles (grille G, source S) du dipôle de commande du tripôle actif 102, tandis que le troisième pôle (drain D) est relié, par l'intermédiaire d'une résistance de protection 104 à la haute tension d'une source d'alimentation, non représentée. La diode 103 est connectée de manière à constituer avec le dipôle de commande G, S un circuit fermé acceptant la circulation du courant dans un seul sens. Ainsi, dans l'exemple de la figure 3, la cathode et l'anode de la diode 103 sont connectées respectivement à la grille et à la source du transistor à effet de champ 102.

La borne de la charge capacitive 110 qui n'est pas reliée à la masse est connectée à l'un des pôles G, S du dipôle de commande du transistor à effet de champ 102, l'autre pôle étant relié à la sortie du circuit convertisseur 10 par l'intermédiaire d'un condensateur d'entrée 101 dont la capacité est très inférieure à celle de la charge capacitive 110. La valeur du condensateur 101 peut ainsi être de l'ordre de dix à vingt fois plus faible que celle de la charge 110.

Dans le cas de la figure 3, le transistor à effet de champ 102 est monté de façon à être commandé par la grille G qui est connectée au condensateur d'entrée 101, la source S étant connectée à la charge 110. Selon un autre mode de réalisation possible (voir Fig. 4) le transistor à effet de champ 102 est monté de façon à être commandé par la source S qui est connectée au condensateur d'entrée 101 tandis que la grille G est connectée à la charge 110.

La diode 103 est avantageusement constituée par une diode rapide du type Zener dont la tension de coude est supérieure à la tension de seuil du transistor 102. D'une manière générale, la diode 103 est une diode rapide à faibles fuites et à faible capacité.

Une diode 302 et une résistance 303 montées en parallèle sont avantageusement connectées entre la masse et la sortie du circuit convertisseur 10, la cathode de la diode 302 étant connectée à la sortie du circuit convertisseur 10 pour le sens de montage du transistor 102 et de la diode 103 représenté sur la figure 3. La diode 302 joue un rôle en cas de mise en court-circuit de la charge 110.

Les moyens 300 de mise en court-circuit volontaire de la charge 110 afin de décharger celle-ci instantanément comprennent un transistor à effet de champ 301 dont la source est reliée à la masse, le drain est connecté à la cathode de la diode 103 par l'intermédiaire d'une résistance 302 et la grille reçoit les signaux $V_C$ de commande de mise encourt-circuit rapide.

Le circuit 200 de décharge prévu pour recevoir des impulsions de commande du circuit convertisseur 20 est destiné à contrôler la vitesse de décroissance de la tension aux bornes de la charge 110. Dans l'exemple de la figure 3 les impulsions issues du circuit convertisseur 20 sont appliquées par l'intermédiaire d'une résistance 211 à l'enroulement primaire d'un élément d'isolement constitué par un transformateur 212 dont l'enroulement secondaire est connecté entre une source de tension de référence basse tension et la grille d'un transistor à effet de champ 213 dont la source est reliée par l'intermédiaire d'une résistance 214 à la source de tension de référence, et le drain est relié par des diodes 215 et 2116 respectivement à la charge 110 et à la borne du condensateur d'entrée 101 reliée au transistor à effet de champ 102.

Le circuit de la figure 3 peut servir da base à la réalisation d'un asservissement grâce à la boucle de régulation 400. Le signal de sortie $V_S$ présent aux bornes de la charge 110 est appliqué à un pont diviseur 401, 402 qui fournit une tension de bouclage appliquée à l'entrée inverseuse d'un amplificateur opérationnel 403. L'entrée non inverseuse de l'amplificateur opérationnel 403 reçoit un signal de tension de référence. Un condensateur 404 est connecté entre l'entrée inverseuse et la sortie de l'amplificateur opérationnel 403. Le signal de contre-réacton délivré en sortie du circuit de régulation 400 permet de piloter les signaux appliqués à l'entrée des convertisseurs 10, 20 d'une façon classique.

Le fonctionnement du dispositif de la figure 3 et plus particulièrement du circuit 100 d'alimentation de la charge 110 sera exposé ci-dessous.

Lorsqu'il apparaît sur l'entrée A du circuit d'alimentation 100 une impulsion, il se produit au moment du front montant de l'impulsion, un accroissement de tension sur la charge 110 qui ne peut en aucun cas dépasser l'amplitude $V_e$ de l'impulsion d'entrée. Le courant disponible pour charger la charge 110 provient de la haute tension d'alimentation, au gain de courant près du transistor 102. Lorsque pendant la durée de l'impulsion la tension $V_e$ de l'impulsion d'entrée est maintenue constante, la tension aux bornes de la charge 110 reste constante aux fuites près des divers éléments 101, 102, 110. Lors du front descendant de l'impulsion d'entrée, une faible partie de la charge du condensateur de sortie 110 est redonnée au condensateur d'entrée 101. La tension de charge du condensateur 101 est approximativement la même que celle du condensateur 110, mais compte tenu du rapport des capacités, la charge redonnée au condensateur d'entrée 101 est faible et ne provoque qu'une chute très minime du niveau de tension de sortie $V_S$ (voir la forme du signal g de la Fig. 2d) qui reste ensuite constant lorsque le signal d'entrée $V_e$ est revenu à zéro en attendant d'augmenter de nouveau d'un palier lors de l'apparition du front montant de l'impulsion suivante. On remarquera ainsi qu'il n'est pas nécessaire de maintenir la commande d'entrée pendant les paliers de sortie.

La diode 103 est prévue pour protéger l'entrée du transistor 102 en inverse, mais joue également un rôle en cas de court-circuit accidentel de la charge 110, sous réserve que la diode 103 soit du type Zener, de tension de coude supérieure à la tension de seuil du transistor 102. Dans ce cas, lorsqu'un court-circuit du condensateur 110 a lieu lorsque celui-ci est chargé, la charge du condensateur d'entrée 101 est évacuée par le trajet formé par les diodes 302 et 103, ce qui diminue la tension d'entrée et donc la f.e.m. de sortie possible.

D'une manière générale, avec le circuit d'alimentation 100, en dessous d'une certaine valeur capacitive, la charge 110 ne permet pas que la tension de sortie croisse. Ainsi, à vide, il ne peut être engendré de haute tension en sortie du circuit 100. Sur une charge résistive, la tension de sortie est simplement de l'ordre de la tension d'entrée de commande, et le courant moyen parcourant la charge résistive sera faible. Ceci est important pour des questions de sécurité.

Le circuit de décharge 200 permet une décroissance par paliers de la tension aux bornes de la charge capacitive 110, à chaque impulsion de commande fournie en B par le circuit convertisseur 20. L'impulsion transmise par le transformateur 212 rend conducteur le transistor 213 et permet une chute de tension aux bornes de la charge capacitive 110 d'une valeur équivalente à l'amplitude de l'impulsion reçue à la fois par décharge de cette charge 110 et du condensateur 101.

Le circuit de la figure 4 montre un autre mode de réalisation, dans lequel deux circuits similaires d'alimentation 100 et de décharge 200 sont couplés pour provoquer la croissance et la décroissance contrôlées du signal de tension présent aux bornes de la charge capacitive 110.

Sur la figure 4, on n'a pas représenté les générateurs d'impulsions de commande 10, 20 qui peuvent être semblables à ceux de la figure 3, ni la boucle de régulation 400, ni les moyens 300 de mise en court-circuit rapide qui peuvent être réalisés d'une façon similaire au cas de la figure 3. Le circuit 100 d'alimentation pourrait également être tout à fait identique à celui de la figure 3. Toutefois, sur la figure 4 on a représenté une variante dans laquelle le transistor à effet de champ 102 est commandé par la source S qui est reliée au condensateur d'entrée 101 tandis que la grille est connectée à la charge capacitive 110. Cette variante permet notamment de réduire la pointe de tension du signal $V_S$ à chaque palier (voir la forme de signal $\triangle$ sur la Fig. 2d).

Le mode de réalisation de la figure 4 diffère essentiellement de celui de la figure 3 par le fait que le circuit de décharge 200 comporte, comme le circuit d'alimentation 100, un condensateur d'entrée 201, un tripôle actif 202, une diode 203 connectée entre les pôles (source et grille) du dipôle de commande du tripôle actif 202, qui est avantageusement constitué par un transistor haute tension à effet de champ V MOS, et un condensateur 204 dont le rôle correspond à celui de la charge capacitive 110 pour le circuit d'alimentation 100. Dans le circuit de décharge 200, le drain du transistor à effet de champ 202 est relié à la charge capacitive 110 qui, lorsqu'elle est chargée, joue le rôle d'une source d'alimentation haute tension. Un élément de référence de tension 205 qui peut être constitué par une diode Zener ou par une source d'alimentation basse tension qui est alors capable de récupérer de l'énergie lors de la décharge de la charge 110, est connecté aux bornes du condensateur de décharge 204.

Pour l'explication du fonctionnement du circuit de décharge 200 de la figure 4 on considèrera que la charge capacitive 110 a été au préalable chargée à un niveau de tension élevé par le circuit d'alimentation 100 commandé par les impulsions appliquées sur l'entrée A. A chaque impulsion d'amplitude $V_e$ appliquée sur l'entrée B, le condensateur 204 se charge au moment du front montant de l'impulsion et la tension aux bornes du condensateur 204 a tendance à croître linéairement en escalier comme dans le cas de la charge capacitive 110 lorsque le circuit d'alimentation 100 reçoit des impulsions en A. Toutefois, du fait de la présence de l'élément 205 qui assure un écrêtage de la tension aux bornes du condensateur 204, la tension réinjectée sur le condensateur d'entrée 201 est limitée à une valeur sensiblement égale à l'amplitude $V_e$ de l'impulsion d'entrée diminuée de la tension de référence $V_z$ au coude de la diode 203 près. Il est possible que la tension de référence $V_z$ soit inférieure à l'amplitude maximale $V_e$ des impulsions en B. Lorsque le niveau des impulsions d'entrée reste constant, comme pour le cas du circuit 100, il ne se produit pas d'évolution des tensions aux bornes de la charge 110 ou du condensateur 204. En revanche, à chaque front descendant d'une impulsion d'entrée A, la charge redonnée au condensateur d'entrée 201 provient de la charge capacitive 110 et ne dépend que de la valeur de l'am-

plitude des impulsions $V_e$ et de la valeur des capacités des condensateurs 110 et 201. Le condensateur 201 est ainsi chargé en inverse à chaque retombée d'impulsion sous une tension voisine de la tension de référence $V_z$ et acquiert une charge empruntée à la charge 110, ce qui produit une chute de tension aux bornes de la charge 110 d'une valeur $\dfrac{Ce\ V_z}{C_t}$ où Ce

est la capacité du condensateur 201, $C_t$ est la capacité de la charge 110 et $V_z$ est la tension de référence de l'élément 205.

On remarque que dans le cas où l'élément 205 de référence de tension est une source de basse tension, celle-ci récupère une partie de l'énergie de la charge 110 à chaque flanc contant de tension en B. L'élément de référence de tension 205 est ainsi avantageusement constitué par la source basse tension alimentant l'ensemble des divers composants constituant l'amplificateur, afin de réaliser la récupération d'une partie de l'énergie qui autrement serait perdue lors des décharges de la charge capacitive 110.

Le circuit 100, 200 de la figure 4 permet ainsi de contrôler entièrement à la fois la charge et la décharge du condensateur 110 à l'aide d'un très petit nombre de composants qui rendent très compact le dispositif, d'ailleurs susceptible d'être réalisé sous la forme d'un circuit hybride unique constituant un module fonctionnel.

Dans les divers modes de réalisation décrits précédemment, on a supposé que les signaux de commande étaient constitués par des impulsions rectangulaires ou sensiblement rectangulaires. Dans certains cas, il peut être avantageux d'utiliser des impulsions de forme trapézoïdale (voir Fig. 5), afin de limiter les courants transitoires sans adjonction de composants spécifiques. En effet, du fait de la présence des condensateurs d'entrée 101, 201 et de l'inclinaison des fronts des impulsions trapézoïdales, il est possible de contrôler les courants transitoires par la pente des impulsions trapézoïdales selon la formule $\triangle i = C\dfrac{\triangle V}{\triangle t}$ où $\triangle i$ est la variation de courant, C

la capacité du condensateur d'entrée et $\dfrac{\triangle V}{\triangle t}$ la pente

des fronts des impulsions trapézoïdales.

Par ailleurs, il est à noter que le mode de commande en fréquence avec les générateurs d'impulsions 10 et 20 permet d'agir facilement sur des oscillations parasites dues soit aux connexions, soit à la nature du diélectrique ou des électrodes de la charge capacitive, en jouant, en boucle fermée ou non sur la fréquence d'attaque en utilisant la phase appropriée vis à vis du phénomène d'oscillations en fonction du résultat souhaité (annulation des oscillations ou au contraire renforcement des oscillations si l'on veut provoquer un adoucissement des variations sur la charge).

Une autre façon de procéder pour agir sur des oscillations parasites consiste à maintenir la fréquence d'attaque fixe et à jouer sur le rapport cyclique, c'est-à-dire la largeur des impulsions de commande.

L'amortissement ou le renforcement des oscillations parasites peuvent ainsi être obtenus sans circuit additionnel spécifique, par la seule modification de la fréquence des signaux de commande ou de leur rapport cyclique.

De par sa souplesse d'emploi, l'amplificateur haute tension conforme à l'invention se prête bien à l'alimentation de dispositifs électro-optiques tels que par exemple des cellules de Kerr, des cellules à cristaux liquides, des panneaux à plasma, des cellules à KDP, des dispositifs électrochromes particuliers, des cellules ferro-électriques utilisant par exemple des titano-zirconates de plomb dopés ou non au lanthane, notamment dans leur applications à des dispositifs télévisuels, de vision binoculaire stéréoscopique ou stroboscopique, ou à d'autres dispositifs électro-optiques tels que des obturateurs, atténuateurs, tubes images ou tubes intensificateurs d'images. Dans tous les cas, l'utilisation de circuits d'attaque du type des circuits représentés sur les figures 3 et 4 contribue à simplifier et rendre plus efficace, l'application d'une tension aux bornes de la charge capacitive.

Dans les exemples décrits en référence aux figures 1 à 5, la tension de sortie aux bornes de la charge capacitive 110 évolue de façon unipolaire entre une valeur à peu près nulle et une valeur positive élevée. Naturellement, avec des composants actifs dont le sens de conduction est inversé et une source d'alimentation de polarité inversée cette tension pourrait également évoluer entre une valeur à peu près nulle et une valeur négative élevée, l'évolution de la valeur absolue de la tension de sortie en fonction des impulsions de commande présentant de la même manière une évolution en marches d'escalier.

Si deux groupes de circuits 100, 200 sont associés et adaptés respectivement à la commande d'une excursion positive de tension et d'une excursion négative de tension aux bornes de la charge capacitive 110, la tension aux bornes de la charge capacitive pourra évoluer de façon alternative et constituer un signal bipolaire.

Ainsi, selon un mode de réalisation possible, le dispositif selon l'invention peut constituer un montage en pont comprenant deux convertisseurs courant-fréquence (10) associés à deux circuits (100) d'application d'une tension en escalier de valeur absolue croissante alimentés respectivement par des sources d'alimentation de polarités opposées et deux convertisseurs courant-fréquence (20) associés à deux circuits (200) d'application d'une tension en escalier de valeur absolue décroissante.

Selon un autre mode de réalisation possible, ne nécessitant que deux circuits d'application de haute tension pour obtenir des signaux bipolaires sur la charge capacitive et permettant d'éviter l'utilisation de composants à structure complémentaire, le dispositif comprend un premier convertisseur courant-fréquence (10) associé à un premier circuit (100) d'application d'une tension en escalier de valeur absolue croissante et un second convertisseur courant-fréquence associé à un second circuit d'application d'une tension en escalier de valeur absolue croissante similaire audit premier circuit (100) mais alimenté par une haute tension flottante par rapport à la masse, et monté tête-bêche par rapport au premier circuit de manière à appliquer des signaux bipolaires sur la charge capacitive (110).

Dans ce cas, le second circuit d'application d'une tension en escalier de valeur absolue croissante alimenté par une haute tension flottante constitue un circuit de décharge de la charge capacitive chargé par le premier circuit 100 et inversement le premier circuit 100 constitue un circuit de décharge de la charge capacitive chargée par le second circuit.

## Revendications

1. Dispositif d'alimentation contrôlée d'une charge capacitive en signaux de tension élevée, comprenant un circuit (10) de production d'impulsions de commande basse tension, un condensateur d'entrée (101) qui présente une capacité très inférieure à celle de la charge capacitive (110) et sur l'une des bornes duquel est appliqué le signal de commande, un élément non linéaire (102) alimenté sous haute tension, qui constitue un tripôle actif avec un dipôle de commande (G, S) et dont l'une des pôles du dipôle de commande est relié à la deuxième borne du condensateur d'entrée (101) tandis que l'autre pôle du dipôle de commande est connecté à l'une des bornes de la charge capacitive de sortie (110) dont l'autre borne est reliée à la masse, et une diode (103) à faibles fuites et à faible capacité qui est connectée entre les deux pôles (G, S) dudit dipôle de commande de manière à constituer avec ce dernier un circuit fermé acceptant la circulation du courant dans un seul sens dans les conditions normales de fonctionnement.

2. Dispositif selon la revendication 1, caractérisé en ce que le circuit (10) de production d'impulsions de commande basse tension comprend un générateur d'impulsions basse tension délivrant des impulsions sensiblement rectangulaires dont la hauteur et la période sont respectivement égales à la hauteur et à la largeur des marches de la tension en escalier qui doit être produite aux bornes de la charge capacitive.

3. Dispositif selon la revendication 1 ou la revendication 2, caractérisé en ce que le tripôle actif (102) est constitué par un transistor à effet de champ du type V-MOS.

4. Dispositif selon l'une quelconque des revendications 1 à 3, caractérisé en ce que la diode (103) connectée entre les deux pôles (G, S) du dipôle de commande du tripôle actif (102) est constituée par une diode Zener dont la tension de coude Zener est supérieure à la tension de seuil du tripôle actif (102).

5. Dispositif selon la revendication 3, caractérisé en ce que la grille (G) du transistor à effet de champ (102) est connectée au condensateur d'entrée (101) tandis que la source (S) est connectée à la charge capacitive de sortie (110).

6. Dispositif selon la revendication 3, caractérisé en ce que la source (S) du transistor à effet de champ (102) est connectée au condensateur d'entrée (101) tandis que la grille (G) connectée à la charge capacitive de sortie (110).

7. Dispositif selon l'une quelconque des revendications 1 à 6, caractérisé en ce qu'il comprend des moyens (300) de mise en court-circuit de la charge capacitive de sortie (110) connectés entre la borne du condensateur d'entrée (101) reliée au tripôle actif (102) et la masse.

8. Dispositif selon la revendication 7, caractérisé en ce que les moyens (300) de mise en court-circuit comprennent une résistance (302) montée en série avec l'espace drain-source d'un transistor à effet de champ (301) commandé par la grille.

9. Dispositif selon l'une quelconque des revendications 1 à 8, caractérisé en ce qu'il comprend en outre un circuit (200) de décharge contrôlée de la charge capacitive de sortie (110), lequel circuit (200) de décharge contrôlée est relié à un second générateur d'impulsions (20) qui délivre des impulsions permettant au circuit (200) de commande de décharge de décharger par palier à chaque impulsion la charge capacitive de sortie (110), la largeur d'un palier correspondant à la période des impulsions issues du second générateur d'impulsions (20).

10. Dispositif selon la revendication 9, caractérisé en ce que le circuit (200) de décharge contrôlée comprend un second condensateur d'entrée (201) sur l'une des bornes duquel est appliqué le signal issu du second générateur d'impulsions (20), un élément non linéaire (202) qui constitue un second tripôle actif, dont l'un des pôles du tripôle de commande (G, S) est relié à la deuxième borne du second condensateur d'entrée (201) tandis que l'autre pôle du dipôle de commande est connecté à l'une des bornes d'un condensateur de décharge (204) dont l'autre borne est reliée à la masse, une diode rapide (203) à faibles fuites et à faible capacité qui est connectée entre les deux pôles (G, S) du dipôle de commande du second tripôle actif (202) de manière à constituer avec ce dernier un circuit fermé acceptant la circulation du courant dans un seul sens, et un élément de référence de tension (205) ou d'écrêtage dont la tension de référence est inférieure à l'amplitude maximale des impulsions fournies par le second générateur d'impulsions (20), et qui est connecté en parallèle sur le condensateur de décharge (204), et en ce que le troisième pôle du second tripôle actif (202) du circuit de décharge contrôlée (200) est relié à la borne de la charge capacitive (110) qui est connectée à l'un des pôles du dipôle de commande (G, S) du premier tripôle actif (102).

11. Dispositif selon l'une quelconque des revendications 1 à 10, caractérisé en ce que le ou les générateurs d'impulsions basse tension (10, 20) délivrent des impulsions de forme trapézoïdale.

12. Amplificateur haute tension à intégration pour charge capacitive, comprenant un premier convertisseur courant-fréquence (10) qui délivre des impulsions basse tension de hauteur et de fréquence prédéterminées pour commander l'application, sur une charge capacitive de sortie (110), d'une tension en escalier croissante dont la hauteur et la largeur des marches correspondent respectivement à l'amplitude et à la période des impulsions délivrées par le premier convertisseur courant-fréquence (10); un second convertisseur courant-fréquence (20) qui délivre des impulsions basse tension de hauteur et de fréquence prédéterminées pour commander l'application, sur la charge capacitive de sortie (110), d'une tension en escalier décroissante dont la largeur des marches correspond à la période des impulsions délivrés par le second convertisseur courant-fréquence (20); un premier circuit (100) d'application d'une tension en escalier croissante qui comprend un condensateur d'entrée (101) auquel sont appliquées les impulsions issues du premier convertisseur courant-fréquence (10), un tripôle actif (102) dont les pôles du dipôle de commande (S, G) sont connectés respectivement au condensateur d'entrée (101) et à la charge capacitive de sortie (110) et le troisième pôle (D) est relié à une source d'alimentation haute tension, et une diode rapide (103) connectée entre les deux pôles dudit dipôle de commande (S, G) de manière à constituer avec ce dernier un circuit fermé acceptant la circulation du courant dans un seul sens; et un second circuit (200) d'application d'une tension en escalier décroissante qui comprend un condensateur d'entrée (201) auquel sont appliquées les impulsions issues du second convertisseur courant-fréquence (20), un tripôle actif (202) dont les pôles du dipôle de commande (S, G) sont connectés respectivement au condensateur d'entrée (201) et à un condensateur de décharge (204) et le troisième pôle (D) est relié à la charge capacitive de sortie (110), une diode rapide (203) connectée entre les deux pôles du dipôle de commande (S, G) de manière à constituer avec ce dernier un circuit fermé acceptant la circulation du courant dans un seul sens, et un élément de référence de tension (205).

13. Amplificateur haute tension selon la revendication 12, caractérisé en ce que l'élément de référence de tension (205) est constitué par la source basse tension alimentant l'ensemble des divers composants constituant l'amplificateur, afin de réaliser une récupération au moins partielle de l'énergie autrement perdue lors des décharges de la charge capacitive (110).

14. Amplificateur haute tension selon la revendication 12 ou la revendication 13, caractérisé en ce qu'il comprend deux convertisseurs courant-fréquence (10) associés à deux circuits (100) d'application d'une tension en escalier de valeur absolue croissante alimentés respectivement par des sources d'alimentation de polarités opposées et deux convertisseurs courant-fréquence (20) associés à deux circuits (200) d'application d'une tension en escalier de valeur absolue décroissante.

15. Dispositif selon l'une quelconque des revendications 1 à 8, caractérisé en ce qu'il comprend un premier convertisseur courant-fréquence (10) associé à un premier circuit (100) d'application d'une tension en escalier de valeur absolue croissante et un second convertisseur courant-fréquence associé à un second circuit d'application d'une tension en escalier de valeur absolue croissante similaire audit premier circuit (100) mais alimenté par une haute tension flottante par rapport à la masse, et monté tête-bêche par rapport au premier circuit de manière à appliquer des signaux bipolaires sur la charge capacitive (110).

**Patentansprüche**

1. Vorrichtung zur geregelten Versorgung einer kapazitiven Last mit hohen Spannungssignalen, mit einem Schaltkreis (10) zur Erzeugung von Niederspannungs-Steuerimpulsen, einem Eingangskondensator (101), der eine Kapazität darstellt, die sehr viel niedriger ist als die der kapazitiven Last (110) und an dessen einer Klemme ein Steuersignal anliegt, einem mit Hochspannung gespeisten nichtlinearen Element (102), das einen aktiven Tripol mit einem Steuerdipol (G, S) bildet, wobei der eine Pol des Steuerdipols mit der zweiten Klemme des Eingangskondensators (101) verbunden ist, während der andere Pol des Steuerdipols an eine der Klemmen der kapazitiven Ausgangslast (110) angeschlossen ist, deren andere Klemme an der Masse liegt, und einer Diode (103) mit geringen Streuverlusten und geringer Kapazität, die zwischen die beiden Pole (G, S) des genannten Steuerdipols derart eingeschaltet ist, dass sie mit diesem letzteren einen geschlossenen Stromkreis bildet, der unter normalen Betriebsbedingungen den Stromfluss in einer einzigen Richtung gestattet.

2. Vorrichtung nach Anspruch 1, dadurch gekennzeichnet, dass der Schaltkreis (10) zur Erzeugung von Niederspannungs-Steuerimpulsen einen Niederspannungs-Impulsgeber umfasst, der merklich rechteckige Impulse liefert, deren Höhe und Dauer jeweils gleich der Höhe und der Breite der Stufen der treppenförmigen Spannung sind, die an den Klemmen der kapazitiven Last erzeugt werden muss.

3. Vorrichtung nach einem der Ansprüche 1 oder 2, dadurch gekennzeichnet, dass der aktive Tripol (102) von einem Feldeffekttransistor vom Typ V-MOS gebildet wird.

4. Vorrichtung nach einem der vorstehenden Ansprüche 1 bis 3, dadurch gekennzeichnet, dass die zwischen die beiden Pole (G, S) des Steuerdipols des aktiven Tripols (102) eingeschaltete Diode (103) von einer Zenerdiode gebildet wird, deren Zenerknickspannung grösser ist als die Schwellenspannung des aktiven Tripols (102).

5. Vorrichtung nach Anspruch 3, dadurch gekennzeichnet, dass das Tor (G) des Feldeffekttransistors (102) an den Eingangskondensator (101) angeschlossen ist, während die Kathode (S) mit der kapazitiven Ausgangslast (110) verbunden ist.

6. Vorrichtung nach Anspruch 3, dadurch gekennzeichnet, dass die Kathode (S) des Feldeffekttransistors (102) an den Eingangskondensator (101) angeschlossen ist, während das Tor (G) mit der kapazitiven Ausgangslast (110) verbunden ist.

7. Vorrichtung nach einem der vorstehenden Ansprüche 1 bis 6, dadurch gekennzeichnet, dass sie Organe (300) zum Kurzschliessen der kapazitiven Ausgangslast (110) umfasst, die zwischen die mit dem aktiven Tripol (102) verbundenen Klemmen des Eingangskondensators (101) und der Masse eingeschaltet sind.

8. Vorrichtung nach Anspruch 7, dadurch gekennzeichnet, dass die Kurzschlussorgane (300) einen Widerstand (302) umfassen, der mit dem Anoden-Kathoden-Raum eines von dem Tor gesteuerten Feldeffekttransistors (102) in Reihe geschaltet ist.

9. Vorrichtung nach einem der vorstehenden Ansprüche 1 bis 8, dadurch gekennzeichnet, dass sie ferner einen von der kapazitiven Ausgangslast (110) geregelten Entladungskreis (200) umfasst, der an einen zweiten Impulsgeber (20) angeschlossen ist, welcher Impulse liefert, die es dem Entladungssteuerkreis (200) ermöglichen, die kapazitive Ausgangslast (110) bei jedem Impuls stufenweise zu entladen, wobei die Breite einer Stufe der Dauer der von dem zweiten Impulsgeber (20) abgegebenen Impulse entspricht.

10. Vorrichtung nach Anspruch 9, dadurch gekennzeichnet, dass der geregelte Entladungskreis (200) einen zweiten Eingangskondensator (201), an dessen eine Klemme das von dem zweiten Impulsgeber (20) abgegebene Signal angelegt wird; ein einen zweiten aktiven Tripol bildendes nichtlineares Element (202), wobei der eine Pol des Steuerdipols (G, S) an die zweite Klemme des zweiten Eingangskondensators (201) angeschlossen ist, während der andere Pol des Steuerdipols mit einer der Klemmen eines Entladungskondensators (204) verbunden ist, dessen andere Klemme an der Masse liegt; eine Schnelldiode (203) mit geringen Steuerverlusten und geringer Kapazität, die zwischen die beiden Pole (G, S) des Steuerdipols des zweiten aktiven Tripols (202) derart eingeschaltet ist, dass sie mit diesem letzteren einen geschlossenen Stromkreis bildet, der den Stromfluss in einer einzigen Richtung gestattet; und ein Bezugsspannungs- oder Begrenzungselement (205) umfasst, dessen Bezugsspannung kleiner ist als die maximale Amplitude der von dem zweiten Impulsgeber (20) gelieferten Impulse, und der mit dem Entladungskondensator (204) parallelgeschaltet ist; und dass der dritte Pol des zweiten aktiven Tripols (202) des geregelten Entladungskreises (200) an die Klemme der kapazitiven Last (110) angeschlossen ist, die ihrerseits mit einem der Pole des Steuerdipols (G, S) des ersten aktiven Tripols (102) verbunden ist.

11. Vorrichtung nach einem der vorstehenden Ansprüche 1 bis 10, dadurch gekennzeichnet, dass der oder die Niederspannungs-Impulsgeber (10, 20) trapezförmige Impulse liefern.

12. Hochspannungs-Integrationsverstärker für kapazitive Last, mit einem ersten Frequenz-Strom-Wandler (10), der Niederspannungsimpulse vorgegebener Höhe und Frequenz abgibt, um einer kapazitiven Ausgangslast (110) eine zunehmende treppenförmige Spannung auszudrücken, deren Stufenhöhe und Stufenbreite jeweils der Höhe und Dauer der von dem ersten Frequenz-Strom-Wandler (10) abgegebenen Impulse entsprechen; mit einem zweiten Frequenz-Strom-Wandler (20), der Niederspannungsimpulse vorgegebener Höhe und Frequenz liefert, um einer kapazitiven Ausgangslast (110) eine abnehmende treppenförmige Spannung aufzudrücken, deren Stufenbreite der Dauer der von dem zweiten Frequenz-Strom-Wandler (20) abgegebenen Impulse entspricht; mit einem ersten Kreis zur Anlegung einer zunehmenden treppenförmigen Spannung, der einen Eingangskondensator (101), an die von dem ersten Frequenz-Strom-Wandler (10) kommenden Impulse abgegeben werden, einen aktiven Tripol (102), dessen Pole des Steuerdipols (G, S) jeweils an den Eingangskondensator (101) und die kapazitive Ausgangslast (110) angeschlossen sind und dessen dritter Pol (D) mit einer Hochspannungsquelle verbunden ist, und mit einer Schnelldiode (103) umfasst, die zwischen den beiden Polen des vorgenannten Dipols (S, G) derart eingeschaltet ist, dass sie mit diesem letzteren einen geschlossenen Stromkreis bildet, der den Stromfluss nur in einer einzigen Richtung gestattet; und mit einem zweiten Stromkreis (200) zur Anlegung einer abnehmenden treppenförmigen Spannung, der einen Eingangskondensator (201), an den die von dem zweiten Frequenz-Strom-Wandler (20) gelieferten Impulse gegeben werden, einen aktiven Tripol (202) mit jeweils an den Eingangskondensator (201) und an einen Entladungskondensator (204) angeschlossenen Polen des Steuerdipols (S, G) und mit einem mit der kapazitiven Ausgangslast (110) verbundenen dritten Pol (D), eine Schnelldiode (203), die zwischen die beiden Pole des Steuerdipols (S, G) derart eingeschaltet ist, dass sie mit diesem letzteren einen geschlossenen Stromkreis bildet, der den Stromfluss nur in einer einzigen Richtung zulässt, und ein Bezugsspannungselement (205) umfasst.

13. Hochspannungsverstärker nach Anspruch 12, dadurch gekennzeichnet, dass das Bezugsspannungselement (205) von der die Gesamtheit der verschiedenen Bauteile des Verstärkers speisenden Niederspannungsquelle gebildet wird, um eine wenigstens teilweise Rückgewinnung der sonst bei den Entladungen der kapazitiven Last (110) verlorenen Energie zu bewirken.

14. Hochspannungsverstärker nach einem der Ansprüche 12 oder 13, dadurch gekennzeichnet, dass er zwei Frequenz-Strom-Wandler (10) umfasst, die zwei Stromkreisen (100) zur Abgabe einer treppenförmigen Spannung von absolut zunehmendem Wert zugeordnet sind, die jeweils von Stromquellen mit entgegengesetzter Polarität gespeist werden, sowie zwei Frequenz-Strom-Wandler (20), die zwei Stromkreisen (200) zur Abgabe einer Spannung von absolut abnehmendem Wert zugeordnet sind.

15. Vorrichtung nach einem der vorstehenden Ansprüche 1 bis 8, dadurch gekennzeichnet, dass sie einen ersten Frequenz-Strom-Wandler (10), der einem ersten Stromkreis (100) zur Abgabe einer treppenförmigen Spannung von absolut zunehmendem Wert zugeordnet ist, und einen zweiten Frequenz-Strom-Wandler umfasst, der einem zweiten Stromkreis zur Abgabe einer treppenförmigen Spannung von absolut zunehmenden Wert zugeordnet ist, der dem ersten Stromkreis (100) ähnlich ist, jedoch von einer im Vergleich zur Masse hohen Leerlaufgleichspannung gespeist wird und im Vergleich zum ersten Stromkreis in entgegengesetzter Richtung derart montiert ist, dass der kapazitiven Last (110) zweipolige Signale aufgedrückt werden.

## Claims

1. A supply device for producing and controlling a stepwise voltage for a capacitive load, the device comprising:
  circuit means (10) for producing low voltage control impulses,
  an input capacitor having first and second terminals and a capacitance (110) which is much lower than that of the capacitive load, where said alternate control signal is applied to the first terminal of said input capacitor,

a non-linear high voltage element (102) comprising an active tripole with a control dipole (G, S), where one of the poles of the control dipole is connected to the second terminal of the input capacitor (101), while the other pole of the control dipole is connected to one of the terminals of the output capacitive load (110), the other terminal of said capacitive load being connected to ground,

a low leak, low capacitive diode (103) connected between the two poles (G, S) of said controle dipole so as to constitue a closed circuit with the latter which accepts current that flows in only one direction under normal operating conditions.

2. A device according to claim 1, wherein said circuit (10) means for producing low voltage control impulses comprises a low voltage impulse generator which issues impulses that are approximately rectangular in shape and of which the height and the period are respectively equal to the height and the width of the steps of the stepwise changing voltage which must be produced at the terminals of the capacitive load.

3. A device according to claim 1, wherein the active tripole (102) further comprises a field effect transistor of the V-MOS type.

4. A device according to claim 1, wherein the diode (103) connected between the two poles (G, S) of the control dipole of the active tripole (102), comprises a Zener diode of which the Zener elbow voltage is greater than the cutoff voltage of the active tripole (102).

5. A device according to claim 3, wherein the grid (G) of the field effect transistor (102) is connected to the input capacitor (101) while its source (S) is connected to the output capacitive load (110).

6. A device according to claim 3, wherein the source (S) of the field effect transistor (102) is connected to the input capacitor (101), while its grid (G) is connected to the output capacitive load (110).

7. A device according to claim 1, further comprising means (300), for selectively short-circuiting said output capacitive load (110), said means being connected between the terminal of the input capacitor (101) which is linked to the active tripole (102) and ground.

8. A device according to claim 7, wherein said selective short-circuiting means (300) comprises a resistor (302) connected in series with the drain-source area of a field effect transistor (301) which is controlled by a signal to its grid.

9. A device according to claim 1, further comprising controlled discharge circuit means (200) for discharging the output capacitive load (110) in a controlled fashion, said controlled circuit (200) means being connected to a second impulse generator (20) which issues impulses that enable the controlled discharge circuit means (200) to discharge the output capacitive load (110) in a stepwise fashion, the width of each step corresponding to the period of impulses from said second impulse generator (20).

10. A device according to claim 9, wherein said controlled discharge circuit (200) means comprises:

a second input capacitor (201) having first and second terminals, to the first terminals of which the signal from the second impulse generator (20) is applied;

a non-linear element (202) comprising a second active tripole having a control dipole, where one of the poles of the control dipole (G, S) is connected to the second terminal of said second input capacitor (201) while the other pole of the control dipole is connected to one of the terminals of a discharge capacitor (204) having two terminals, the other terminal of which is connected to ground,

a low leak, low capacitance quick diode (203) connected between the two poles (G, S) of the control dipole of the second active tripole (202) so as to comprise a closed circuit with the latter which accepts current that flows in only one direction,

a voltage reference element (205) of which the reference voltage is smaller than the maximum amplitude of the impulses supplied by the second impulse generator (20), and which is connected in parallel with said discharge capacitor (204),

and where the third pole of said second active tripole (202) is connected to the terminal of the capacitive load (110) which is connected to one of the poles of the control dipole (G, S) of the first active tripole (102).

11. A device according to any of claims 1 to 10, wherein the low voltage impulse generator (10, 20) issues impulses which are trapezoid-shaped.

12. A high voltage amplifier for a capacitive load comprising:

a first current-frequency converter (10) for providing low voltage impulses having a pre-set height and frequency in order to control the application to the output capacitive load (110) of voltage increasing in a stepwise fashion, wherein the height and width of the steps correspond respectively to the amplitude and the period of the impulses that are issued by the first current-frequency converter (10),

a second current-frequency converter (20) for providing low voltage impulses having a pre-set height and frequency in order to control the application to the output capacitive load (110) of a voltage decreasing in a stepwise fashion, wherein the width of the steps corresponds to the period of the impulses that are issued by the second current-frequency converter (20),

first circuit means (100) for applying said increasing voltage, said first circuit means comprising:

an input capacitor (101) to which the impulses from said first current-frequency converter (10) are applied;

an active tripole (102) having a control dipole, wherein the poles of the control dipole (G, S) are respectively connected to the input capacitor (101) and to the output capacitive load (110), and wherein the third pole (D) of said active tripole is connected to a high voltage supply; and

a low leak, low capacitance quick diode (103) connected between the two poles of said control dipole (G, S) so as to comprise a closed circuit with the latter which accepts a current that flows in only one direction;

second circuit means (200) for applying said decreasing voltage, said second circuit means comprising:

a second input capacitor (201) to which the impulses from said second current-frequency converter (20) are applied;

a second active tripole (202) having a control dipole, wherein the poles of the control dipole (G, S) are respectively connected to the second input capacitor (201) and to a discharging capacitor (204) and wherein the third pole (D) of said second tripole is connected to the output capacitive load (110);

a quick diode (203) connected between the two poles of the control dipole (G, S) of said second tripole so as to comprise a closed circuit with the latter which accepts a circuit that flows in only one direction; and

a voltage clipping element (205) connected in parallel with said discharge capacitor.

13. A high voltage amplifier according to claim 12, wherein said voltage clipping element (205) further comprises the low voltage source which supplies all of the various components which constitute the amplifier for achieving the recovery of part of the energy which would otherwise be lost during discharges of said capacitive load (110).

14. A high voltage amplifier according to any of claims 12 or 13 further comprising two current-frequency converters (10) associated with two circuit means (100) for applying a voltage with an absolute stepwise increasing value, each of said means being respectively supplied by voltage sources with opposite polarities, and two current-frequency converters (20) associated with two circuit means (200) for applying a voltage with an absolute stepwise decreasing value, each of said means being respectively supplied by voltage sources with opposite polarities.

15. A device according to any of claims 1 to 8, further comprising a first current-frequency converter associated with first circuit means for applying a voltage with an absolute stepwise increasing value and a second current-frequency converter associated with second circuit means for applying a voltage with an absolute stepwise decreasing value that is similar to said circuit means but supplied by a high voltage source, the voltage of which is floating with respect to ground and assembled top to bottom in relation to the initial circuit so as to apply two-pole signals to the output capacitive load.

ENTRÉE ↗

C/C RAPIDE

ENTRÉE ↘

+HT (1000V...)

100, 200, 300

E

A

C

B

Fig.1

$V_S$

$C_S$  110

$V_A$

F ENTRÉE ↗    t

Fig.2a

$V_B$

F ENTRÉE ↘    t

Fig.2b

$V_C$

C/C RAPIDE    t

Fig.2c

g    s

$V_S$

Vcs    t

Fig.2d

0 119 927

Fig. 3

0 119 927

Fig. 4

Fig. 5